# EUROPÄISCHE PATENTANMELDUNG

(11) **EP 1 006 411 A2**
(43) Veröffentlichungstag der Anmeldung: **07.06.2000**
(21) Anmeldenummer: 99121084.0
(22) Anmeldetag: 22.10.1999
(51) Int. Cl.: G03F 7/20

(54) **Beleuchtungssystem für die VUV-Mikrolithographie**

(30) Priorität: 30.11.1998 DE 19855106
(71) Anmelder: Carl Zeiss, 89518 Heidenheim (Brenz) (DE); CARL-ZEISS-STIFTUNG, trading as CARL ZEISS, 89518 Heidenheim (DE)
(72) Erfinder: Wangler, Johannes, 89551 Königsbronn (DE)

(57) **Zusammenfassung**

Beleuchtungssystem für die VUV-Mikrolithographie (bei 157 nm) mit einer VUV-Lichtquelle (1), refraktiven optischen Elementen aus Fluorid, mindestens einem Mikrolinsenarray (3, 5) als Lichtleitwert-erhöhendem Element und mindestens einem Wabenkondensor (7a, 7b). Der Wabenkondensor ist vorzugsweise aus gekreuzten Zylinderlinsenarrays aufgebaut.

## Beschreibung

Ausgehend von der Entwicklung der Mikrolithographie-Projektionsbelichtungsanlagen zur Verwendung immer niedrigerer Lichtwellenlängen befindet sich auch die 157 nm-Technik auf Basis des F₂-Excimerlasers seit einiger Zeit in der Entwicklung.

Im DUV-Bereich liegen bereits Erfahrungen mit geeigneten Beleuchtungssystemen vor mit verschiedenen Komponenten und Funktionen, die auch bei der 157 nm-Technik benötigt werden, um ein ausreichend großes Feld homogen, telezentrisch und mit wählbarem Kohärenzgrad σ auszuleuchten.

Problem ist dabei aber, daß die verfügbaren transmittierenden Stoffe stark eingeschränkt sind. Nur CaF₂ ist als Optikwerkstoff bereits etabliert und hinreichend durchlässig. Als brauchbar bekannt sind auch andere Fluoride. Allerdings ist auf kürzeste Glaswege zu achten, da die Absorption im Vergleich zu bekannten DUV-Systemen deutlich erhöht ist und die Strahlungsbeständigkeit vermindert ist.

Aufgabe der Erfindung ist es daher, ein Beleuchtungssystem anzugeben, das diesen verschiedenen Anforderungen im VUV-Bereich gerecht wird.

Gelöst wird diese Aufgabe durch ein Beleuchtungssystem nach Anspruch 1. Vorteilhafte Ausführungsformen sind Gegenstand der Unteransprüche 2 bis 8 und 12 bis 13. Ansprüche 9 bis 11 geben als Kernstück einen besonderen Wabenkondensor an.

Die Erfindung baut dabei auf den Erkenntnissen der für DUV geeigneten DE 195 20 563 A1 auf. Sie geht jedoch für das Lichtmischelement von dem dort bevorzugten Glasstab ab, da dieser lang ist und damit hohe Absorption aufweist, und geht auf den bei konventionellen Beleuchtungssystemen auch bekannten Wabenkondensor über.

Näher erläutert wird die Erfindung anhand der Zeichnung.

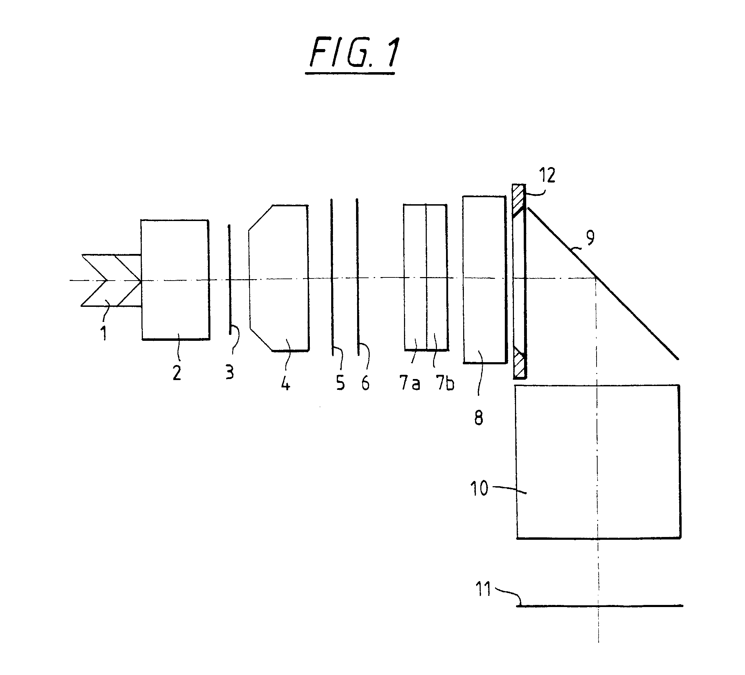

- Figur 1: zeigt schematisch eine Übersicht über ein Ausführungsbeispiel eines erfindungsgemäßen Beleuchtungssytems.

In Figur 1 ist 1 ein VUV-Excimer-Laser, also insbesondere ein F₂-Laser mit 157 nm Wellenlänge. Das Strahlübertragungs- und -Aufweitsystem 2 liefert das Licht an die Projektionsbelichtunganlage und paßt den Bündelquerschnitt an den Bedarf an. Der Lichtleitwert (auch Etendu oder Lagrange-Invariante) ist wegen der geringen Divergenz des Lasers 1 (ca. 1 mrad) aber minimal und reicht bei weitem nicht zur Füllung der notwendigen Apertur eines Projektionsobjektivs mit geeignetem Bildfeld aus. Zwei Mikrolinsenarrays 3 und 5 vorzugsweise aus CaF₂ dienen zur Einführung eines erhöhten Lichtleitwerts, wobei ein zwischengeschaltetes Zoom-Objektiv 4 die Anpassung des Kohärenzgrads σ (oder der Pupillenfüllung) ermöglicht. In bekannter Weise kann im Zoom-Objektiv 4 auch ein verstellbares Axicon integriert sein, das u.a. variable Ringaperturbeleuchtung ermöglicht.

Das zweite Mikrolinsenarray 5 hat vorzugsweise Einzelelemente mit einer Form, insbesondere mit einer Rechteckform, mit einem ähnlichen Aspektverhältnis wie die Retikel-Maske und wie das Objekt- und Bild-Feld des vorgesehenen Projektionsobjektivs.

Element 6 ist eine als Option vorgesehene Streuscheibe mit diffuser Streuung, z.B. eine geätzte CaF₂-Scheibe, zur Verbesserung von Lichtleitwert und Homogenität.

7a und 7b sind die beiden Linsenraster eines Wabenkondensors. Sie können z.B. als Mikrolinsenarray (Anbieter z.B. Teledyne Brown Engineering, Huntsville, AL, USA) ausgebildet sein oder jeweils aus einem Paar gekreuzter Zylinder-Stapel bestehen, in der Art wie aus G.A. Carts, Laser Focus World, November 1991, page 39 bekannt. Die Anzahl der Rasterelemente wird jedoch um eine Größenordnung oder mehr angehoben. Zum Beispiel ist ein Querschnitt von 4 x 4 cm² mit Stablinsen von 1mm Dicke, also mit größenordnungsmäßig 10² bis 10³ und mehr Stablinsen, bzw jeweils eine Größenordnung mehr Arrayelementen, vorgesehen. Die beiden Linsenraster 7a, 7b sind bei einem Wabenkondensor in den gegenseitigen Brennebenen angeordnet - anders als bei Carts a.a.O.. Als Material wird CaF₂ oder ein anderes Fluorid vorgesehen. Der Durchmesser des Wabenkondensors geht bis zu ca. 100 mm.

Daran anschließend sind Relaisoptik 8, planer Umlenkspiegel 9 und Feldlinsenoptik 10 angeordnet. Vorzugsweise sind darin auch asphärische Linsen vorgesehen, um die Linsenzahl und die gesamte Glasdicke gering zu halten. Integriert ist auch vorzugsweise ein Retikel-Maskiersystem 12, also eine Feldblende, das dann exakt auf das Retikel 11 (Maske) abgebildet wird. Das Retikel-Maskiersystem 12 ist verstellbar, um genaue Anpassung an das Objektfeld der Maske zu ermöglichen.

Die große Elementzahl des Wabenkondensors 7a, 7b, also die feine Rasterung; sorgt dabei gegenüber bekannten Arrays mit ca. 10 Elementen in jeder Richtung für eine gleichmäßige Funktion über das gesamte Feld, wenn die Pupille variiert wird.

Die Techniken der diffraktiven Optik (DOE), der binären Optik und der Zonenplatten (Fresnel-Linsen) sind sehr geeignet um sowohl die Lichtleitwert-erhöhenden Elemente 3, 5 als auch die Linsenarrays der Wabenkondensoren 7a, 7b auszubilden.

Dieses System hat alle für ein Beleuchtungssystem der Mikrolithographie erforderlichen funktionalen Elemente in einer Weise vereint, die auch im VUV-Bereich, z.B. bei 157 nm, ausreichende Transmission gewährleistet. Insbesondere Zoomobjektiv 4, einschließlich Axicon, Relais 8 und Feldlinse 10 können auch Spiegel enthalten, vorzugsweise als katadioptrische Systeme. Neben CaF₂ kann für die transmittierenden optischen Elemente auch anderes Material, z.B. Fluoride, eingesetzt werden.

## Patentansprüche

1. Beleuchtungssystem der VUV-Mikrolithographie mit
- einer VUV-Lichtquelle (1), insbesondere einem F₂-Laser mit 157 nm Wellenlänge
- refraktiven optischen Elementen aus Fluorid, insbesondere Kalziumfluorid
- mindestens einem Mikrolinsenarray (3, 5) ais Lichtleitwert-erhöhendem Element
- mindestens einem Wabenkondensor (7a, 7b).

2. Beleuchtungssystem nach Anspruch 1, dadurch gekennzeichnet, daß ein Wabenkondensor (7a, 7b) aus gekreuzten Zylinderlinsenarrays, insbesondere aufgebaut aus Stablinsen, enthalten ist.

3. Beleuchtungssystem nach Anspruch 1 oder 2, dadurch gekennzeichnet, daß auch Spiegel (9) und/oder refraktive optische Elemente aus anderem Material enthalten sind.

4. Beleuchtungssystem nach mindestens einem der Ansprüche 1 bis 3; dadurch gekennzeichnet, daß zwei Mikrolinsenarrays (3, 5) vorhanden sind und dazwischen ein Objektiv (4) angeordnet ist.

5. Beleuchtungssystem nach Anspruch 4, dadurch gekennzeichnet, daß das dazwischen angeordnete Objektiv (4) ein Zoom-Objektiv ist und zur Verstellung des Kohärenzgrads der Beleuchtung dient.

6. Beleuchtungssystem nach Anspruch 4 oder 5, dadurch gekennzeichnet, daß das zweite Mikrolinsenarray (5) Rasterelemente annähernd geometrisch ähnlich dem ausgeleuchteten Feld aufweist.

7. Beleuchtungssystem nach mindestens einem der Ansprüche 1 bis 6, dadurch gekennzeichnet, daß dem Wabenkondensor (7a, 7b) ein Relais (8) und eine Feldlinse (10) nachgeordnet sind.

8. Beleuchtungssystem nach mindestens einem der Ansprüche 1, 2 und 4 bis 7, dadurch gekennzeichnet, daß es rein refraktiv aufgebaut ist, mit Ausnahme von möglichen Umlenkspiegeln (9).

9. Wabenkondensor, bestehend aus zwei Platten mit je zwei Arrays (7a, 7b) aus gekreuzten Zylinderlinsen aus Kalziumfluorid, wobei jedes Array aus größenordnungsmäßig 10² bis 10⁴ Zylinderlinsen besteht.

10. Wabenkondensor nach Anspruch 9, dadurch gekennzeichnet, daß die Arrays (7a, 7b) aus gestapelten Stäben aufgebaut sind.

11. Wabenkondensor nach Anspruch 9, dadurch gekennzeichnet, daß die Arrays (7a, 7b) aus mikrostrukturierten Platten bestehen.

12. Beleuchtungssystem nach Anspruch 2, dadurch gekennzeichnet, daß ein Wabenkondensor (7a, 7b) nach mindestens einem der Ansprüche 9 bis 11 enthalten ist.

13. Beleuchtungssystem nach mindestens einem der Ansprüche 1 bis 12, dadurch gekennzeichnet, daß ein verstellbares Retikel-Maskiersystem (12) enthalten ist.

14. Beleuchtungssystem nach mindestens einem der Ansprüche 1 bis 13, dadurch gekennzeichnet, daß mindestens ein Mikrolinsenarray (3, 5) oder ein Array (7a, 7b) des Wabenkondensors aus diffraktiven, binär optischen oder Zonenplatten-Elementen aufgebaut ist.
